# EUROPEAN PATENT SPECIFICATION

(11) **EP 3 264 166 B1**
(45) Date of publication and mention of the grant of the patent: **29.04.2020**
(21) Application number: 16779583.0
(22) Date of filing: 12.04.2016
(51) Int. Cl.: G02F 1/025, H01L 21/02, G02F 1/225

(54) **SILICON-BASED MODULATOR AND METHOD FOR FABRICATION THEREOF**
SILICIUMBASIERTER MODULATOR UND VERFAHREN ZUR HERSTELLUNG DAVON
MODULATEUR À BASE DE SILICIUM ET SON PROCÉDÉ DE FABRICATION

(30) Priority: 14.04.2015 CN 201510175428
(43) Date of publication of application: 03.01.2018
(73) Proprietor: ZTE Corporation, Shenzhen, Guangdong 518057 (CN)
(72) Inventor: HUA, Feng, Shenzhen Guangdong 518057 (CN); WANG, Huitao, Shenzhen Guangdong 518057 (CN); XU, Peng, Shenzhen Guangdong 518057 (CN); WU, Dongping, Guangdong 518057 (CN); FU, Chaochao, Guangdong 518057 (CN); WANG, Yan, Guangdong 518057 (CN)
(74) Representative: Baudler, Ron
(86) International application number: PCT/CN2016/079060
(87) International publication number: WO 2016/165608

(56) References cited:
- WO-A1-2014/185951
- CN-A- 103 226 252
- CN-U- 202 563 200
- CN-U- 204 155 033
- US-A1- 2006 008 223
- US-A1- 2011 058 764
- US-A1- 2011 176 762
- US-A1- 2014 341 497

## Description

### Technical Field

The present invention relates to the technical field of silicon-based photoelectrons, and more particularly to a silicon-based modulator and a method for fabricating the silicon-based modulator.

### Background

A photo-modulator serving as a key component in a silicon-based photo-electronic system adopts a light-source internal modulation manner at the very beginning, and the internal modulation manner is gradually evolved into an external modulation manner due to a bandwidth limitation. At present, a commercial external modulator structure is a Mach-Zehnder Interferometer (MZI) structure, and to be effectively integrated with a silicon-based integrated circuit, a photoelectric modulator having a silicon-based MZI structure emerges. The silicon-based MZI structure is divided into three modes, i.e., an accumulation type mode, an injection type mode and a depletion type mode. Since the depletion type mode has the shortest response time and the largest bandwidth, a depletion type MZI modulator is the current commonest modulator structure.

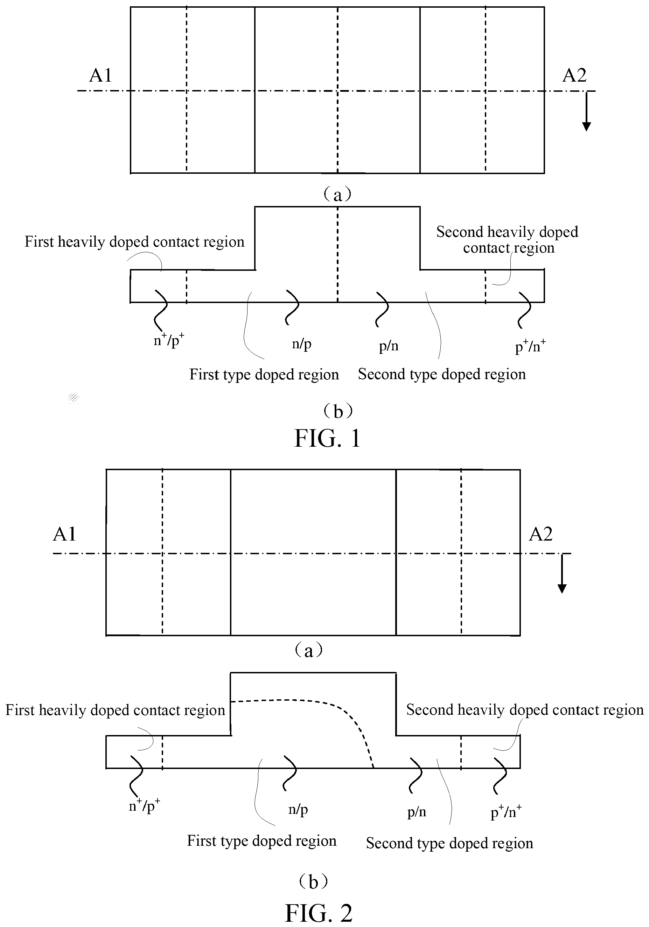

At present, the structure of the common depletion type MZI modulator is a simple longitudinal single-PN junction structure. As shown in FIG. 1, the structure includes: a first heavily doped contact region, a second heavily doped contact region, and a first type doped region of a modulation arm and a second type doped region of the modulation arm. The heavily doped contact regions are located at the left and right sides of the modulation arm, and a modulation arm working region is located in the middle of the modulation arm. The first type doped region and the second type doped region in the modulation arm are longitudinally and symmetrically distributed. A PN junction is located in a contact region between the first type doped region and the second type doped region. Since the PN junction in this structure is short in length and small in function range, the modulation efficiency is low, a very long device is needed to effectively realize modulation, which is poor for integration of devices.

The document US2014341497A1 discloses a novel phase shifter design for carrier depletion-based silicon modulators, based on an experimentally validated model.

The document US2011058764A1 discloses a high-performance electro-optic modulating device providing the characteristics such as high-speed, high modulation efficiency, miniaturization, low power consumption, and low optical waveguide loss.

The document US2011176762A1 discloses an optical modulator and a method of fabricating the optical modulator.

### Summary

To solve the technical problem in the related technology of low modulation efficiency, the embodiments of the present invention provide a silicon-based modulator and a fabricating method thereof.

To solve the abovementioned technical problem, the technical solution is adopted as follows.

A silicon-based modulator in accordance with claim 1 is provided.

In an example of the present invention, the first heavily doped contact region, the first type doped region, the second type doped region and the second heavily doped contact region are p+, p, n and n+ regions, respectively, or n+, n, p and p+ regions, respectively.

In one example, the second type doped region in the modulation arm working region half-surrounds the first type doped region, and an intersection line of a first plane and the PN junction between the first type doped region and the second type doped region of the modulation arm working region presents as a J-like curve.

Herein, the first plane is a longitudinal section of the silicon-based modulator.

In one example, when the silicon-based modulator is looked down, there are multiple strip-shaped first type doped regions and multiple strip-shaped second type doped regions in the modulation arm working region. The strip-shaped first type doped regions and the strip-shaped second type doped regions are distributed in an alternating continuous manner. All the strip-shaped first type doped regions run through each other, and all the strip-shaped second type doped regions run through each other. An intersection line of a first plane and PN junctions between the first type doped regions and the second type doped regions of the modulation arm working region presents as a rectangular wave-like broken line.

Herein, the first plane is a longitudinal section of the silicon-based modulator.

Herein, the strip-shaped first type doped regions and the strip-shaped second type doped regions are all parallel to a contact plane between the first heavily doped contact region or the second heavily doped contact region and the modulation arm working region.

In one example, when the silicon-based modulator is looked down, the second type doped regions in the modulation arm working region are distributed in the first type doped regions in a dot matrix manner. Some intersection lines of a first plane and PN junctions between the first type doped regions and the second type doped regions of the modulation arm working region present as rectangular wave-like broken lines. Some intersection lines present as L-like broken lines. The first type doped regions are connected in an integral run-through manner, and the second type doped regions are connected in an integral run-through manner.

Herein, the first plane is a longitudinal section of the silicon-based modulator. The first plane corresponding to the intersection lines presented as the rectangular wave-like broken lines and the first plane corresponding to the intersection lines presented as the L-like broken lines are two different planes.

A method for fabricating a silicon-based modulator in accordance with claim 4 is provided.

In one example, the operation that a second type doped region is formed by utilizing directly the ion injection manner to obtain a modulation arm working region includes the step as follows.

Second type ions are injected into the optical waveguide for one or more times within a set angle range, and then the injected second type ions are annealed and activated to form the second type doped region with the set ion concentration, to obtain a modulation arm working region.

Herein, the set angle range is an angle of 15 to 75 degrees relative to a vertical direction, and parallelism to a horizontal connecting line between the first heavily doped contact region and the second heavily doped contact region.

In one example, the operation that a second type doped region is formed by utilizing the etching process and the ion injection manner to obtain a modulation arm working region includes the steps as follows.

A pattern of the second type doped region on a horizontal plane is set by utilizing the etching process, herein the pattern is multiple strips spaced from each other.

Second type ions are vertically and longitudinally injected into a pattern region corresponding to the second type doped region, and a photosensitive material on the first type doped region is removed.

The second type ions are injected into the optical waveguide for one or more times within a set angle range.

The injected second type ions are annealed and activated to form a second type doped region with the set ion concentration, to obtain a modulation arm working region.

Herein, the set angle range is an angle of 15 to 75 degrees relative to a vertical direction, and parallelism to a horizontal connecting line between the first heavily doped contact region and the second heavily doped contact region.

In one example, the operation that a second type doped region is formed by utilizing the etching process and the ion injection manner to obtain a modulation arm working region includes the steps as follows.

A pattern of a second type doped region on a horizontal plane is set by utilizing the etching process, herein the pattern is a dot matrix shape.

Second type ions are vertically and longitudinally injected into a pattern region corresponding to the second type doped region, and a photosensitive material on the first type doped region is removed.

The second type ions are injected into the optical waveguide for one or more times within a set angle range.

The injected second type ions are annealed and activated to form the second type doped region with the set ion concentration, to obtain a modulation arm working region.

Herein, the set angle range is an angle of 15 to 75 degrees, relative to a vertical direction, and parallelism to a horizontal connecting line between the first heavily doped contact region and the second heavily doped contact region.

The examples provide a silicon-based modulator and a method for fabricating the silicon-based modulator. The silicon-based modulator includes: a first heavily doped contact region, a second heavily doped contact region, and a modulation arm working region including a first type doped region and a second type doped region. The first heavily doped contact region and the second heavily doped contact region are located at the left and right sides of the modulation arm working region, respectively. The first heavily doped contact region is connected with the first type doped region. A PN junction is formed in a contact region between the first type doped region and the second type doped region. An area of the contact region formed between the first type doped region and the second type doped region in the modulation arm working region is greater than an area of the smallest contact region between the first type doped region and the second type doped region. Compared with the function range of a PN junction of a traditional silicon-based modulator, the function range of the PN junction of the silicon-based modulator in the examples is expanded to some extent, thereby greatly improving the adjustment efficiency and facilitating integration of devices. In addition, the method for fabricating the silicon-based modulator in the examples of the present invention is stable and reliable, and high in repeatability.

### Brief Description of Drawings

In the drawings (not necessarily drawn in proportion), similar drawing marks may describe similar parts in different views. The similar drawing marks having different letter suffixes may represent different examples for the similar parts. The drawings substantially show various examples discussed herein in an example manner instead of a limitation manner.
FIG. 1 (a) is a planform structure diagram illustrating a traditional depletion type MZI modulator (longitudinal single PN junction).
FIG. 1 (b) is a sectional structure diagram illustrating the traditional depletion type MZI modulator (longitudinal single PN junction) along an A1-A2 line in FIG. 1 (a).
FIG. 2 (a) is a planform structure diagram illustrating a silicon-based modulator according to one example of the present invention.
FIG. 2 (b) is a sectional structure diagram illustrating the silicon-based modulator along an A1-A2 line in FIG. 2 (a).
FIG. 3 (a) is a planform structure diagram illustrating the silicon-based modulator according to another example of the present invention.
FIG. 3 (b) is a sectional structure diagram illustrating the silicon-based modulator along an A1-A2 line in FIG. 3 (a).
FIG. 4 (a) is a planform structure diagram illustrating the silicon-based modulator according to another example of the present invention.
FIG. 4 (b) is a sectional structure diagram illustrating the silicon-based modulator along an A1-A2 line in FIG. 4 (a).
FIG. 4 (c) is a sectional structure diagram illustrating the silicon-based modulator along a B1-B2 line in FIG. 4 (a).
FIG. 5 to FIG. 8 are sectional views illustrating several corresponding intermediate structures in a traditional silicon-based modulation fabricating flow.
FIG. 9 is a sectional view illustrating a structure obtained by ion injection for the silicon-based modulator according to Example four.
FIG. 10 is a sectional view illustrating a structure obtained by a first ion injection for the silicon-based modulator according to Example five.
FIG. 11 is a sectional view illustrating a structure obtained by a second ion injection for the silicon-based modulator according to Example five.
FIG. 12 is a sectional view illustrating a structure obtained by a first ion injection for the silicon-based modulator according to Example six.
FIG. 13 is a sectional view illustrating a structure obtained by a second ion injection for the silicon-based modulator according to Example six.

### Detailed Description

The following is a brief introduction for a subject described herein in detail. The brief introduction is not intended to restrict the scope of protection of claims.

Examples provide a silicon-based modulator. The silicon-based modulator includes: a first heavily doped contact region, a second heavily doped contact region, and a modulation arm working region including a first type doped region and a second type doped region. The first heavily doped contact region and the second heavily doped contact region are located at the left and right sides of the modulation arm working region, respectively. The first heavily doped contact region is connected with the first type doped region. A PN junction is formed in a contact region between the first type doped region and the second type doped region. And an area of the contact region formed between the first type doped region and the second type doped region in the modulation arm working region is greater than an area of a smallest contact region between the first type doped region and the second type doped region.

In an example, the smallest contact region between the first type doped region and the second type doped region may be a contact region between a first type doped region and a second type doped region longitudinally and symmetrically distributed as shown in FIG. 1.

In an example, the first heavily doped contact region, the first type doped region, the second type doped region and the second heavily doped contact region are p+, p, n and n+ regions, respectively, or n+, n, p and p+ regions, respectively.

In one example, the second type doped region in the modulation arm working region half-surrounds the first type doped region, and an intersection line of the PN junction between the first type doped region and the second type doped region of the modulation arm working region and a first plane is presented as a J-like curve.

Herein, the first plane is a longitudinal section of the silicon-based modulator.

In one example, when the silicon-based modulator is looked down, there are multiple strip-shaped first type doped regions and multiple strip-shaped second type doped regions in the modulation arm working region. The strip-shaped first type doped regions and the strip-shaped second type doped regions are distributed in an alternating continuous manner. All the strip-shaped first type doped regions run through each other. And all the strip-shaped second type doped regions run through each other. An intersection line of PN junctions between the first type doped regions and the second type doped regions of the modulation arm working region and a first plane is presented as a rectangular wave-like broken line.

Herein, the first plane is a longitudinal section of the silicon-based modulator.

Herein, the strip-shaped first type doped regions and the strip-shaped second type doped regions may be all parallel to a contact plane between the first heavily doped contact region or the second heavily doped contact region and the modulation arm working region.

In one example, when the silicon-based modulator is looked down, the second type doped regions in the modulation arm working region are distributed in the first type doped regions in a dot matrix manner. Some intersection lines of PN junctions between the first type doped regions and the second type doped regions of the modulation arm working region and a first plane are presented as rectangular wave-like broken lines, and some intersection lines are presented as L-like broken lines. The first type doped regions are connected in an integral run-through manner. And the second type doped regions are connected in an integral run-through manner.

Herein, the first plane is a longitudinal section of the silicon-based modulator. The first plane corresponding to the intersection lines presented as the rectangular wave-like broken lines and the first plane corresponding to the intersection lines presented as the L-like broken lines are two different planes.

Compared with the function range of a PN junction of a traditional silicon-based modulator, the function range of the PN junction of the silicon-based modulator in the examples of the present invention is expanded to some extent, thereby greatly improving the adjustment efficiency and facilitating integration of devices.

The present invention will be further elaborated hereinbelow in conjunction with the drawings and specific examples.

### Example one

FIG. 2 is a structure diagram illustrating a silicon-based modulator according to one example. As shown in FIG. 2, the silicon-based modulator includes: a first heavily doped contact region, a second heavily doped contact region, and a modulation arm working region including a first type doped region and a second type doped region. And the first heavily doped contact region and the second heavily doped contact region are located at the left and right sides of the modulation arm working region, respectively. The first heavily doped contact region is connected with the first type doped region. A PN junction is formed in a contact region between the first type doped region and the second type doped region. Herein, the second type doped region in the modulation arm working region half-surrounds the first type doped region, and an intersection line of the PN junction between the first type doped region and the second type doped region of the modulation arm working region and a first plane is presented as a J-like curve.

In combination with the illustration of FIG. 2 (a) and (b), the first plane is formed by sectioning along an A1-A2 line when the silicon-based modulator is looked down.

Herein, the first heavily doped contact region, the first type doped region, the second type doped region and the second heavily doped contact region are p+, p, n and n+ regions, respectively, or n+, n, p and p+ regions, respectively.

### Example two

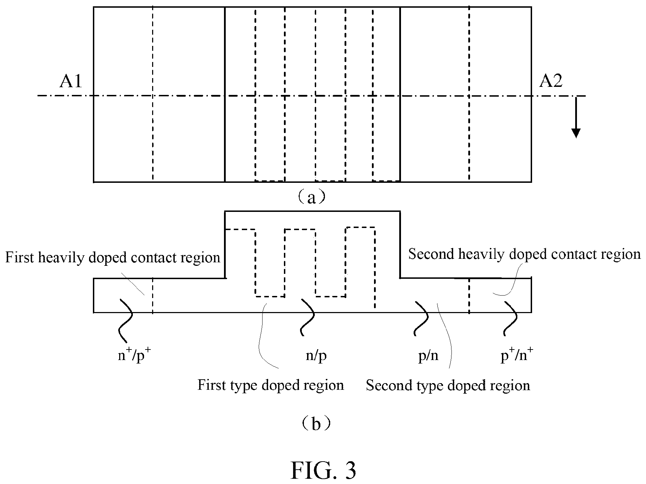

FIG. 3 is a structure diagram illustrating the silicon-based modulator according to another example. As shown in FIG. 3, the silicon-based modulator includes: a first heavily doped contact region, a second heavily doped contact region, and a modulation arm working region including a first type doped region and a second type doped region. And the first heavily doped contact region and the second heavily doped contact region are located at the left and right sides of the modulation arm working region, respectively. The first heavily doped contact region is connected with the first type doped region. A PN junction is formed in a contact region between the first type doped region and the second type doped region. Herein, when the silicon-based modulator is looked down, there are multiple strip-shaped first type doped regions and multiple strip-shaped second type doped regions in the modulation arm working region. The strip-shaped first type doped regions and the strip-shaped second type doped regions are distributed in an alternating continuous manner. All the strip-shaped first type doped regions run through each other. All the strip-shaped second type doped regions run through each other. An intersection line of PN junctions between the first type doped regions and the second type doped regions of the modulation arm working region and a first plane is presented as a rectangular wave-like broken line.

Herein, in combination with the illustration of FIG. 3 (a) and (b), the first plane is formed by sectioning along an A1-A2 line when the silicon-based modulator is looked down. The strip-shaped first type doped regions and the strip-shaped second type doped regions are all parallel to a contact plane between the first heavily doped contact region or the second heavily doped contact region and the modulation arm working region.

### Example three

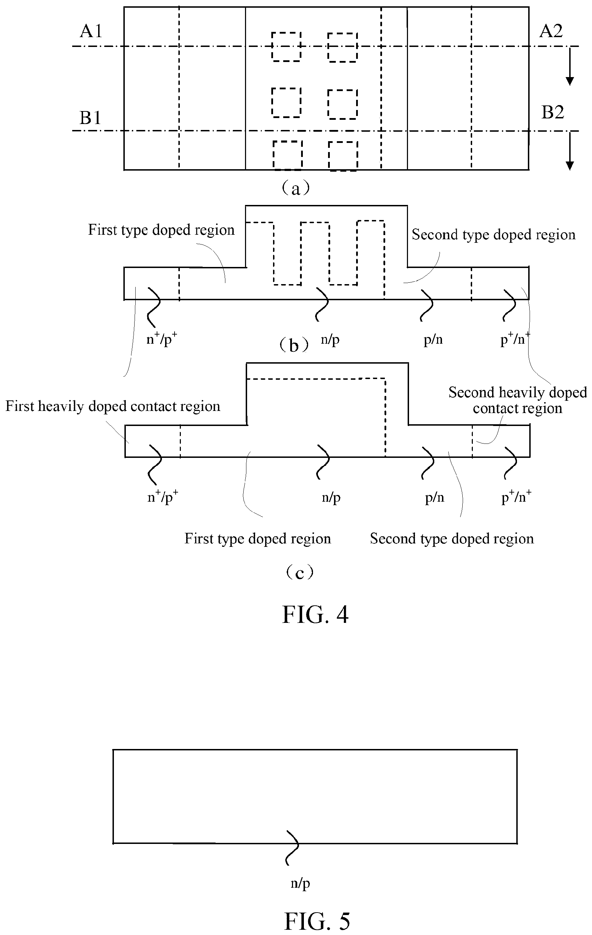

FIG. 4 is a structure diagram illustrating the silicon-based modulator according to another example. As shown in FIG. 4, the silicon-based modulator includes: a first heavily doped contact region, a second heavily doped contact region, and a modulation arm working region including a first type doped region and a second type doped region. And the first heavily doped contact region and the second heavily doped contact region are located at the left and right sides of the modulation arm working region, respectively. The first heavily doped contact region is connected with the first type doped region. A PN junction is formed in a contact region between the first type doped region and the second type doped region. Herein, when the silicon-based modulator is looked down, the second type doped regions in the modulation arm working region are distributed in the first type doped regions in a dot matrix manner. Some intersection lines of PN junctions between the first type doped regions and the second type doped regions of the modulation arm working region and a first plane are presented as rectangular wave-like broken lines, and some intersection lines are presented as L-like broken lines. The first type doped regions are connected in an integral run-through manner, and the second type doped regions are connected in an integral run-through manner.

Herein, in combination with the illustration of FIG. 4 (a), (b) and (c), the first plane is a longitudinal section of the silicon-based modulator. The first plane corresponding to the intersection lines presented as the rectangular wave-like broken lines and the first plane corresponding to the intersection lines presented as the L-like broken lines are two different planes. The intersection lines presented as the rectangular wave-like broken lines are located on a section formed by sectioning along an A1-A2 line. The intersection lines presented as the L-like broken lines are located on a section formed by sectioning along a B1-B2 line.

The method for fabricating the silicon-based modulator in the examples will be described hereinbelow.

First, a method for fabricating a traditional silicon-based modulator as shown in FIG. 1 is simply described. The method includes the steps as follows.

In step 1, a first type (n or p type) doped SOI substrate is provided, and a substrate of which the doping concentration is in a range from 1E17cm-3 to 1E19cm-3 is directly used, or the doping concentration is adjusted to be within this range by using an ion injection manner, as shown in FIG. 5.

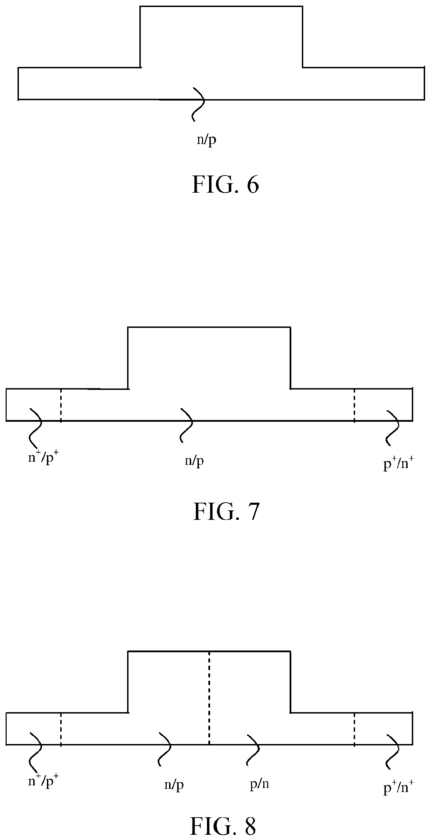

In step 2, an optical waveguide is fabricated by utilizing a photo-etching process, to obtain a structure as shown in FIG. 6.

In step 3, contact regions at two sides of the optical waveguide are set by utilizing the photo-etching process, and then corresponding ions are injected by utilizing an ion injection manner respectively, to implement a heavily doped region of which the doping concentration is in a range from 1E19cm-3 to 1E21cm-3, as shown in FIG. 7.

In step 4, a second type (p or n type) ion doped region is set by utilizing the photo-etching process.

In step 5, second type ions are vertically and longitudinally injected, and the injected ions are annealed and activated, herein the annealed second doping concentration range is 1E17cm-3 to 1E19cm-3, and the structure is as shown in FIG. 8.

On the basis of the abovementioned traditional fabricating method, an example further provides a method for fabricating a silicon-based modulator. The method includes the steps as follows.

A first type doped substrate is formed, and an optical waveguide is fabricated from the first type doped substrate by utilizing an etching process.

Contact regions at two sides of the optical waveguide are formed by utilizing the etching process, and then first type ions or second type ions with a set concentration are injected into the two contact regions respectively by utilizing an ion injection manner, to form a first heavily doped contact region and a second heavily doped contact region.

The method further includes the steps as follows.

A second type doped region is formed by directly utilizing the ion injection manner, to obtain a modulation arm working region. Or, a pattern of a second type doped region on a horizontal plane is set by utilizing the etching process, and second type ions with a set concentration are then injected by utilizing the ion injection manner, and the second type doped region is formed by annealing, to obtain a modulation arm working region.

Herein, an area of a contact region formed between a first type doped region and the second type doped region in the modulation arm working region is greater than an area of the smallest contact region between the first type doped region and the second type doped region.

The first type doped region and the second type doped region form a P region and an N region in a PN junction by doping.

The doped regions in this case are of a non-special shape, so the substrate of a first type doped region may be formed by means of an ion diffusion process or an ion injection process.

After all processes for forming the heavily doped regions and the second type doped region are completed, the remaining first type doped region substrate part is the first type doped region.

In one example, the operation that a second type doped region is formed by directly utilizing the ion injection manner to obtain a modulation arm working region includes the step as follows.

Second type ions are injected into the optical waveguide for one or more times within a set angle range, and then the injected second type ions are annealed and activated to form a second type doped region with a set ion concentration, to obtain a modulation arm working region.

Herein, the set angle range is an angle of 15 to 75 degrees relative to a vertical direction, and parallelism to a horizontal connecting line between the first heavily doped contact region and the second heavily doped contact region.

In one example, the operation that a second type doped region is formed by utilizing the etching process and the ion injection manner to obtain a modulation arm working region includes the steps as follows.

A pattern of the second type doped region on a horizontal plane is set by utilizing the etching process, and the pattern is multiple strips spaced from each other.

Second type ions are vertically and longitudinally injected into a pattern region corresponding to the second type doped region, and a photosensitive material on the first type doped region is removed.

The second type ions are injected into the optical waveguide for one or more times within a set angle range.

The injected second type ions are annealed and activated to form a second type doped region with a set ion concentration, to obtain a modulation arm working region.

Herein, the set angle range is an angle of 15 to 75 degrees relative to a vertical direction, and parallelism to a horizontal connecting line between the first heavily doped contact region and the second heavily doped contact region.

In one example, the operation that a second type doped region is formed by utilizing the etching process and the ion injection manner to obtain a modulation arm working region includes the steps as follows.

A pattern of a second type doped region on a horizontal plane is set by utilizing the etching process, and the pattern is a dot matrix shape.

Second type ions are vertically and longitudinally injected into a pattern region corresponding to the second type doped region, and a photosensitive material on the first type doped region is removed.

The second type ions are injected into the optical waveguide for one or more times within a set angle range.

The injected second type ions are annealed and activated to form a second type doped region with a set ion concentration, to obtain a modulation arm working region.

Herein, the set angle range is an angle of 15 to 75 degrees relative to a vertical direction, and parallelism to a horizontal connecting line between the first heavily doped contact region and the second heavily doped contact region.

The present invention will be described in detail hereinbelow in conjunction with the drawings and specific examples.

### Example four

The structure of the silicon-based modulator in the present example is as shown in FIG. 2. A fabricating method thereof is as follows.

Step 1 to step 3 are completely identical to those of the above traditional method for fabricating the silicon-based modulator, and will not be elaborated herein.

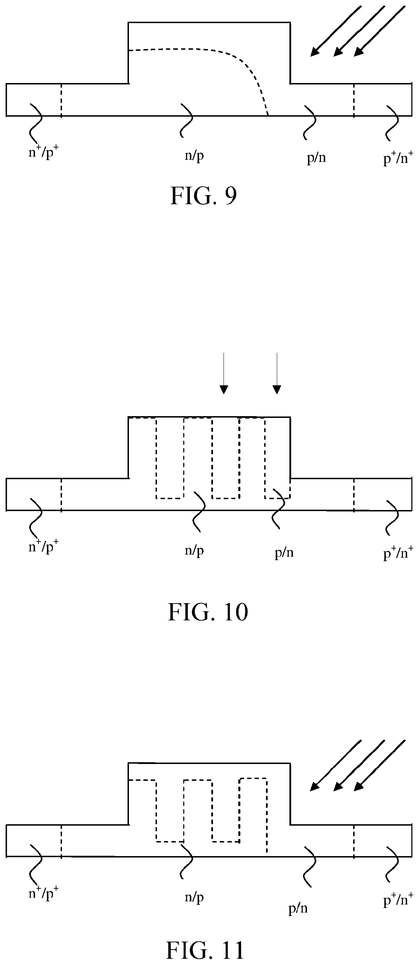

In step 4, an ion injection angle (presenting 15 to 75 degrees relative to a vertical direction, and parallel to the A1-A2 line in FIG. 2) is adjusted, and second type ions are injected for one or more times (it can be ensured that the second type ions are not injected into a first type doped region at the left, namely an n/p region by adjusting the injection angle or increasing the area of a heavily doped contact region at the left namely an n+/p+ region), and the depth (the depth is higher as the energy is higher) and concentration (the concentration is higher as the dosage is higher) of a PN junction are controlled by adjusting the injection energy and dosage of the second type ions, to make a PN junction region close to a middle position of a modulation arm working region to the greatest extent finally. And then the injected ions are annealed and activated, and the doping concentration range of the annealed second type ions is 1E17cm-3 to 1E19cm-3, as shown in FIG. 9.

Compared with a traditional longitudinal single-PN junction modulator, the examples of the present invention have the advantages as follows.
(1) The function range of a PN junction of the modulator in the present example is larger (both the length and the area are increased to some extent), and by utilizing COMSOL fine element software simulation, it can be found that when the doping concentration is 1E18cm-3, the modulation efficiency of an MZI modulator having a broken line PN junction structure as shown in FIG. 2 is two times that of the traditional longitudinal single-PN junction modulator.
(2) A fabricating process of the MZI modulator having the folded line PN junction structure omits the existing step of setting a second type ion doped region by utilizing a photo-etching technology, thereby effectively reducing the fabricating cost, and also eliminating the problems about error and yield brought by this step.
(3) The second type doped region of the MZI modulator having the folded line PN junction structure is implemented by adjusting the ion injection angle. However, the second type doped region of the traditional longitudinal single-PN junction modulator is set in the step of photo-etching. Under a practical situation, compared with the step of photo-etching, the step of adjusting the ion injection angle is higher in reliability, stability and consistency, so fabrication of the MZI modulator having the folded line PN junction structure is higher as a whole in repeatability and reliability.

### Example five

The structure of the silicon-based modulator of the present example is as shown in FIG. 3. The fabricating method thereof is as follows.

Step 1 to step 3 are completely identical to those of the above traditional method for fabricating the silicon-based modulator, and will not be elaborated herein.

In step 4, a pattern of a strip-shaped second type doped region on a horizontal plane is set by utilizing a photo-etching technology.

In this step, those skilled in the art can know that when the pattern of the second type doped region on the horizontal plane is set, it is required to coat a photosensitive material such as photoresist, and after the pattern of the second type doped region on the horizontal plane is formed, the photoresist on a first type doped region is not removed yet to prevent second type ions from being injected into the first type doped region when the second type ions are injected subsequently for the first time.

In step 5, during first-time injection of the second type ions, the second type ions are vertically and longitudinally injected to obtain a single/multi-junction strip-shaped injection structure as shown in FIG. 10, and then the photoresist on the first type doped region is removed.

In step 6, during second-time injection of the second type ions, an ion injection angle (presenting 15 to 75 degrees relative to a vertical direction, and parallel to the A1-A2 line in FIG. 3) is adjusted, and the second type ions are injected for one or more times to communicate multiple strip-shaped structures. As mentioned above, the depth and concentration of a PN junction are controlled by adjusting the energy and dosage of the ion injection. The injection depth is close to a surface position of the modulation arm working region to the greatest extent. And the injected second type ions are annealed and activated, and the doping concentration range of the annealed second type ions is 1E17cm-3 to 1E19cm-3, to obtain the structure as shown in FIG. 11. The position of the PN junction in an optical waveguide is adjusted to realize modulation efficiency as high as possible.

Compared with a traditional longitudinal single-PN junction modulator, the examples have the advantages as follows.
(1) The function range of a PN junction of an MZI modulator having a strip-shaped PN junction structure is larger. By utilizing COMSOL fine element software simulation, it can be found that when the doping concentration is 3E18cm-3, the modulation efficiency of the MZI modulator having the strip-shaped PN junction structure is three times that of the traditional longitudinal single-PN junction modulator.
(2) Although the step of injecting second type ions for the second time is added to the fabricating process of the MZI modulator having the strip-shaped PN junction structure, the process cost and complexity of this step are not high, and the reliability and the consistency are good, so the expense is low due to this step.

### Example six

A structure of the silicon-based modulator of the present example is as shown in FIG. 4. The fabricating method thereof is as follows.

Step 1 to step 3 are completely identical to those of the above traditional method for fabricating the silicon-based modulator, and will not be elaborated herein.

In step 4, a pattern of a dot matrix shaped second type doped region on a horizontal plane is set by utilizing a photo-etching technology.

In this step, those skilled in the art can know that when the pattern of the second type doped region on the horizontal plane is set, it is required to coat a photosensitive material such as photoresist, and after the pattern of the second type doped region on the horizontal plane is formed, the photoresist on a first type doped region is not removed yet to prevent second type ions from being injected into the first type doped region when the second type ions are injected subsequently for the first time.

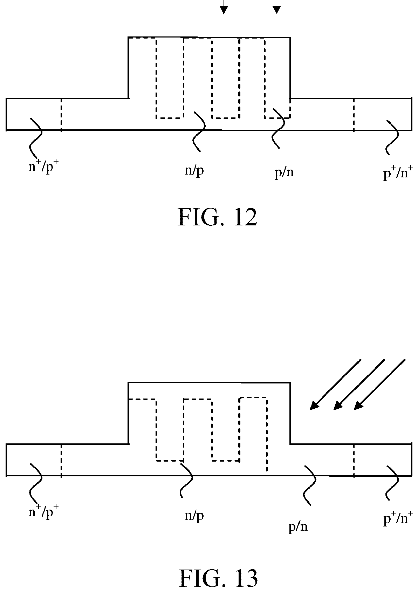

In step 5, during first-time injection of the second type ions, the second type ions are vertically and longitudinally injected to implement a multi-column injection structure, and then the photoresist on the first type doped region is removed, to obtain a structure as shown in FIG. 12 (sectional view of a silicon-based modulator along an A1-A2 line in FIG. 4).

In step 6, during second-time injection of the second type ions, an ion injection angle (presenting 15 to 75 degrees relative to a vertical direction, and parallel to the A1-A2 line in FIG. 3) is adjusted, and the second type ions are injected for one or more times to communicate multiple columnar structures. The depth and concentration of a PN junction are controlled by adjusting the energy and dosage of ion injection. The injection depth is close to a surface position of a modulation arm working region to the greatest extent. The injected second type ions are annealed and activated, and the doping concentration range of the annealed second type ions is 1E17cm-3 to 1E19cm-3, to obtain a structure as shown in FIG. 13. The position of the PN junction in an optical waveguide is adjusted to realize modulation efficiency as high as possible.

Compared with a traditional longitudinal single-PN junction modulator, the examples of the present invention have the advantages as follows.
(1) The function range of a PN junction of an MZI modulator having a dot matrix PN junction structure is larger, so the modulation efficiency of the modulator can be effectively improved.
(2) Although the step of injecting second type ions for the second time is added to the fabricating process of the MZI modulator having the dot matrix PN junction structure, the process cost and complexity of this step are not high, and the reliability and the consistency are good, so the expense is low due to this step.

After the drawings and the detailed descriptions are read and understood, other aspects can be understood.

Those skilled in the art shall understand that the examples may be provided as a method, a system or a computer program product.

The present invention is described with reference to flowcharts and/or block diagrams of the method, the device (system) and the computer program product according to the examples. It will be appreciated that each flow and/or block in the flowcharts and/or the block diagrams and a combination of the flows and/or the blocks in the flowcharts and/or the block diagrams may be implemented by computer program instructions. These computer program instructions may be provided for a general computer, a dedicated computer, an embedded processor or processors of other programmable data processing devices to generate a machine, such that an apparatus for implementing functions designated in one or more flows of the flowcharts and/or one or more blocks of the block diagrams is generated via instructions executed by the computers or the processors of the other programmable data processing devices.

These computer program instructions may also be stored in a computer readable memory capable of guiding the computers or the other programmable data processing devices to work in a specific mode, such that a manufactured product including an instruction apparatus is generated via the instructions stored in the computer readable memory, and the instruction apparatus implements the functions designated in one or more flows of the flowcharts and/or one or more blocks of the block diagrams.

These computer program instructions may also be loaded to the computers or the other programmable data processing devices, such that processing implemented by the computers is generated by executing a series of operation steps on the computers or the other programmable devices, and therefore the instructions executed on the computers or the other programmable devices provide a step of implementing the functions designated in one or more flows of the flowcharts and/or one or more blocks of the block diagrams.

The above is only the alternative examples and not used to limit the scope of protection of the present invention.

### Industrial Applicability

The examples provide a silicon-based modulator and a method for fabricating the silicon-based modulator. The silicon-based modulator includes: a first heavily doped contact region, a second heavily doped contact region, and a modulation arm working region including a first type doped region and a second type doped region. Herein the first heavily doped contact region and the second heavily doped contact region are located at the left and right sides of the modulation arm working region, respectively. The first heavily doped contact region is connected with the first type doped region. A PN junction is formed in a contact region between the first type doped region and the second type doped region. An area of the contact region formed between the first type doped region and the second type doped region in the modulation arm working region is greater than an area of a smallest contact region between the first type doped region and the second type doped region. Compared with the function range of a PN junction of a traditional silicon-based modulator, the function range of the PN junction of the silicon-based modulator in the examples of the present invention is expanded to some extent, thereby greatly improving the adjustment efficiency and facilitating integration of devices. In addition, the method for fabricating the silicon-based modulator in the examples is stable and reliable, and high in repeatability. Therefore, the present invention as claimed has strong industrial applicability.

## Claims

1. A silicon-based modulator, comprising: a first heavily doped contact region, a second heavily doped contact region, and a modulation arm working region comprising a first type doped region and a second type doped region, the first heavily doped contact region and the second heavily doped contact region being located at left and right sides of the modulation arm working region, respectively, the first heavily doped contact region being connected with the first type doped region, a PN junction being formed in a contact region between the first type doped region and the second type doped region, wherein an area of the contact region formed between the first type doped region and the second type doped region in the modulation arm working region is greater than an area of a smallest contact region between the first type doped region and the second type doped region; **characterized in that**:
when the silicon-based modulator is looked down, there are a plurality of strip-shaped first type doped regions and a plurality of strip-shaped second type doped regions in the modulation arm working region; and the plurality of strip-shaped first type doped regions and the plurality of strip-shaped second type doped regions are distributed in an alternating continuous manner, and all the strip-shaped first type doped regions are connected and run through each other, and all the strip-shaped second type doped regions are connected and run through each other, and an intersection line of a first plane and PN junctions between the first type doped regions and the second type doped regions of the modulation arm working region presents as a rectangular wave-like broken line; wherein the first plane is a longitudinal section of the silicon-based modulator; or
when the silicon-based modulator is looked down, the second type doped regions in the modulation arm working region are distributed in the first type doped regions in a dot matrix manner; and some intersection lines of a first plane and PN junctions between the first type doped regions and the second type doped regions of the modulation arm working region present as rectangular wave-like broken lines, and some intersection lines present as L-like broken lines, and the first type doped regions are connected in an integral run-through manner, and the second type doped regions are connected in an integral run-through manner; wherein the first plane is a longitudinal section of the silicon-based modulator, and the first plane corresponding to the intersection lines presented as the rectangular wave-like broken lines and the first plane corresponding to the intersection lines presented as the L-like broken lines are two different planes.

2. The silicon-based modulator according to claim 1, wherein the first heavily doped contact region, the first type doped region, the second type doped region and the second heavily doped contact region are p+, p, n and n+ regions, respectively, or n+, n, p and p+ regions, respectively.

3. The silicon-based modulator according to claim 1, wherein the plurality of strip-shaped first type doped regions and the plurality of strip-shaped second type doped regions are all parallel to a contact plane between the first heavily doped contact region or the second heavily doped contact region and the modulation arm working region.

4. A method for fabricating a silicon-based modulator according to claims 1-3, **characterized by** comprising:
forming a first type doped substrate, and fabricating an optical waveguide from the first type doped substrate by utilizing an etching process;
forming contact regions at two sides of the optical waveguide by utilizing the etching process, and then injecting first type ions or second type ions with a set concentration into the two contact regions respectively by utilizing an ion injection manner, to form a first heavily doped contact region and a second heavily doped contact region;
the method further comprising:
setting a pattern of the second type doped region on a horizontal plane by utilizing the etching process, and then injecting second type ions with a set concentration by utilizing the ion injection manner, and forming the second type doped region by annealing, to obtain the modulation arm working region;
wherein an area of a contact region formed between a first type doped region and the second type doped region in the modulation arm working region is greater than an area of a smallest contact region between the first type doped region and the second type doped region;
wherein the setting a pattern of the second type doped region on a horizontal plane by utilizing the etching process, and then injecting second type ions with a set concentration by utilizing the ion injection manner, and forming the second type doped region by annealing, to obtain the modulation arm working region comprises:
setting the pattern of the second type doped region on a horizontal plane by utilizing the etching process;
vertically and longitudinally injecting the second type ions into a pattern region corresponding to the second type doped region, and removing a photosensitive material on the first type doped region;
injecting the second type ions into the optical waveguide for one or more times within a set angle range; and
annealing and activating the injected second type ions to form the second type doped region with the set ion concentration, to obtain the modulation arm working region.

5. The method according to claim 4, wherein the pattern is a plurality of strips spaced from each other;
wherein the set angle range is: an angle of 15 to 75 degrees relative to a vertical direction, and parallelism to a horizontal connecting line between the first heavily doped contact region and the second heavily doped contact region.

6. The method according to claim 4, wherein the pattern is a dot matrix shape;
wherein the set angle range is: an angle of 15 to 75 degrees relative to a vertical direction, and parallelism to a horizontal connecting line between the first heavily doped contact region and the second heavily doped contact region.

## Patentansprüche

1. Ein Modulator auf Siliziumbasis, bestehend aus: einem ersten stark dotierten Kontaktbereich, einem zweiten stark dotierten Kontaktbereich und einem Arbeitsbereich des Modulationsarms, der einen dotierten Bereich vom ersten Typ und einen zweiten dotierten Bereich vom zweiten Typ umfasst, wobei der erste stark dotierte Kontaktbereich und der zweite stark dotierte Kontaktbereich auf der linken und rechten Seite des Arbeitsbereichs des Modulationsarms angeordnet sind, wobei der erste stark dotierte Kontaktbereich mit dem ersten dotierten Bereich verbunden ist, wobei ein PN-Übergang in einem Kontaktbereich zwischen dem dotierten Bereich vom ersten Typ und dem dotierten Bereich vom zweiten Typ gebildet wird, wobei eine Fläche des Kontaktbereichs, der zwischen dem dotierten Bereich vom ersten Typ und dem dotierten Bereich vom zweiten Typ im Arbeitsbereich des Modulationsarms gebildet wird, größer ist als eine Fläche eines kleinsten Kontaktbereichs zwischen dem dotierten Bereich vom ersten Typ und dem dotierten Bereich vom zweiten Typ; **dadurch gekennzeichnet, dass**:
wenn man den siliziumbasierten Modulator von unten betrachtet, es eine Vielzahl von streifenförmigen dotierten Bereichen vom ersten Typ und eine Vielzahl von streifenförmigen dotierten Bereichen vom zweiten Typ im Arbeitsbereich des Modulationsarms gibt; und die Vielzahl der streifenförmigen dotierten Bereiche vom ersten Typ und die Vielzahl der streifenförmigen dotierten Bereiche vom zweiten Typ in einer alternierenden kontinuierlichen Weise verteilt sind, und alle streifenförmigen dotierten Bereiche vom ersten Typ miteinander verbunden sind und durch einander verlaufen, und alle streifenförmigen dotierten Bereiche vom zweiten Typ miteinander verbunden sind und durch einander verlaufen, und eine Schnittlinie einer ersten Ebene und PN-Übergänge zwischen den dotierten Bereichen vom ersten Typ und den dotierten Bereichen vom zweiten Typ des Arbeitsbereichs des Modulationsarms als eine rechteckwellenähnliche unterbrochene Linie darstellt; wobei die erste Ebene ein Längsschnitt des siliziumbasierten Modulators ist; oder
wenn man den siliziumbasierten Modulator von unten betrachtet, die dotierten Bereiche vom zweiten Typ im Arbeitsbereich des Modulationsarms in den dotierten Bereichen vom ersten Typ in einer Punktmatrixweise verteilt sind; und einige Schnittlinien einer ersten Ebene und PN-Übergänge zwischen den dotierten Bereichen vom ersten Typ und den dotierten Bereichen vom zweiten Typ des Arbeitsbereichs des Modulationsarms als rechteckige wellenförmige gestrichelte Linien und einige Schnittlinien als L-ähnliche gestrichelte Linien vorliegen, und die dotierten Bereiche vom ersten Typ in einer integralen Durchgangsweise verbunden sind, und die dotierten Bereiche vom zweiten Typ in einer integralen Durchgangsweise verbunden sind; wobei die erste Ebene ein Längsschnitt des siliziumbasierten Modulators ist, und die erste Ebene, die den Schnittlinien entspricht, die als die rechteckigen wellenartigen gestrichelten Linien dargestellt sind, und die erste Ebene, die den Schnittlinien entspricht, die als die L-artigen gestrichelten Linien dargestellt sind, zwei verschiedene Ebenen sind.

2. Modulator auf Siliziumbasis nach Anspruch 1, wobei der erste stark dotierte Kontaktbereich, der dotierte Bereich vom ersten Typ, der dotierte Bereich vom zweiten Typ und der zweite stark dotierte Kontaktbereich p+, p, n bzw. n+ Bereiche oder n+, n, p bzw. p+ Bereiche sind.

3. Modulator auf Siliziumbasis nach Anspruch 1, wobei die Vielzahl der streifenförmigen dotierten Bereiche vom ersten Typ und die Vielzahl der streifenförmigen dotierten Bereiche vom zweiten Typ alle parallel zu einer Kontaktebene zwischen dem ersten stark dotierten Kontaktbereich oder dem zweiten stark dotierten Kontaktbereich und dem Arbeitsbereich des Modulationsarms liegen.

4. Verfahren zur Herstellung eines Modulators auf Siliziumbasis nach den Ansprüchen 1-3, **dadurch gekennzeichnet, dass** es umfasst:
Bilden eines dotierten Substrats vom ersten Typ und Herstellen eines Lichtwellenleiters aus dem dotierten Substrat vom ersten Typ unter Verwendung eines Ätzprozesses;
Bilden von Kontaktbereichen an zwei Seiten des Lichtwellenleiters unter Verwendung des Ätzverfahrens und dann Injizieren von Ionen des ersten Typs oder Ionen des zweiten Typs mit einer festgelegten Konzentration in die beiden Kontaktbereiche, um einen ersten stark dotierten Kontaktbereich und einen zweiten stark dotierten Kontaktbereich zu bilden;
ferner umfasst das Verfahren:
das Setzen eines Musters des dotierten Bereichs des zweiten Typs auf einer horizontalen Ebene unter Verwendung des Ätzprozesses und dann das Injizieren von Ionen des zweiten Typs mit einer festgelegten Konzentration unter Verwendung des loneninjektionsverfahrens und das Bilden des dotierten Bereichs des zweiten Typs durch Aushärten, um den Arbeitsbereich des Modulationsarms zu erhalten;
wobei eine Fläche eines Kontaktbereichs, der zwischen einem dotierten Bereich vom ersten Typ und dem dotierten Bereich vom zweiten Typ in dem Arbeitsbereich des Modulationsarms gebildet wird, größer ist als eine Fläche eines kleinsten Kontaktbereichs zwischen dem dotierten Bereich vom ersten Typ und dem dotierten Bereich vom zweiten Typ;
wobei das Setzen eines Musters des dotierten Bereichs vom zweiten Typ auf einer horizontalen Ebene unter Verwendung des Ätzprozesses und dann das Injizieren von Ionen des zweiten Typs mit einer festgelegten Konzentration unter Verwendung des loneninjektionsverfahrens und das Bilden des dotierten Bereichs vom zweiten Typ durch Aushärten, um den Arbeitsbereich des Modulationsarms zu erhalten, umfasst:
Setzen des Musters des dotierten Bereichs des zweiten Typs auf einer horizontalen Ebene unter Verwendung des Ätzverfahrens;
Injizieren von Ionen des zweiten Typs in vertikaler und longitudinaler Richtung in einen Musterbereich, der dem dotierten Bereich des zweiten Typs entspricht, und Entfernung eines lichtempfindlichen Materials auf dem dotierten Bereich des ersten Typs;
Injizieren von Ionen des zweiten Typs in den Lichtwellenleiter für ein oder mehrere Male innerhalb eines festgelegten Winkelbereichs; und
Aushärten und Aktivieren der injizierten Ionen des zweiten Typs, um den dotierten Bereich des zweiten Typs mit der festgelegten lonenkonzentration zu bilden, um den Arbeitsbereich des Modulationsarms zu erhalten.

5. Verfahren nach Anspruch 4, wobei das Muster aus einer Vielzahl von voneinander beabstandeten Streifen besteht;
wobei der festgelegte Winkelbereich ist: ein Winkel von 15 bis 75 Grad relativ zu einer vertikalen Richtung und parallel zu einer horizontalen Verbindungslinie zwischen dem ersten stark dotierten Kontaktbereich und dem zweiten stark dotierten Kontaktbereich.

6. Verfahren nach Anspruch 4, wobei das Muster eine Punktmatrixform ist;
wobei der festgelegte Winkelbereich ist: ein Winkel von 15 bis 75 Grad relativ zu einer vertikalen Richtung und parallel zu einer horizontalen Verbindungslinie zwischen dem ersten stark dotierten Kontaktbereich und dem zweiten stark dotierten Kontaktbereich.

## Revendications

1. Un modulateur à base de silicium, comprenant : une première région de contact fortement dopée, une seconde région de contact fortement dopée, et une région de travail de bras de modulation comprenant une région dopée d'un premier type et une région dopée d'un second type, la première région de contact fortement dopée et la seconde région de contact fortement dopée étant situées respectivement à gauche et à droite de la région de travail de bras de modulation, la première région de contact fortement dopée étant reliée à la région dopée d'un premier type, une jonction PN étant formée dans une région de contact entre la région dopée d'un premier type et la région dopée d'un second type, dans laquelle une zone de la région de contact formée entre la région dopée d'un premier type et la région dopée d'un second type dans la région de travail du bras de modulation est supérieure à une zone d'une plus petite région de contact entre la région dopée d'un premier type et la région dopée d'un second type ; **caractérisé en ce que** :
lorsque le modulateur à base de silicium est regardé d'en bas, il y a une pluralité de régions dopées d'un premier type en forme de bandes et une pluralité de régions dopées d'un second type en forme de bandes dans la région de travail du bras de modulation ; et la pluralité de régions dopées d'un premier type en forme de bande et la pluralité de régions dopées d'un second type en forme de bande sont distribuées de manière continue et alternée, et toutes les régions dopées d'un premier type en forme de bande sont connectées et se croisent, et toutes les régions dopées d'un second type en forme de bande sont connectées et se croisent, et une ligne d'intersection d'un premier plan et des jonctions PN entre les régions dopées d'un premier type et les régions dopées d'un second type de la région de travail du bras de modulation se présente sous la forme d'une ligne brisée rectangulaire en forme d'onde ; dans lequel le premier plan est une section longitudinale du modulateur à base de silicium ; ou
lorsque le modulateur à base de silicium est regardé d'en bas, les régions dopées d'un second type dans la région de travail du bras de modulation sont distribuées dans les régions dopées d'un premier type de manière matricielle en points ; et certaines lignes d'intersection d'un premier plan et les jonctions PN entre les régions dopées d'un premier type et les régions dopées d'un second type de la région de travail du bras de modulation se présentent sous la forme de lignes rectangulaires en forme d'ondes brisées, et certaines lignes d'intersection se présentent sous la forme de lignes en forme de L brisées, et les régions dopées d'un premier type sont connectées de manière continue et intégrale, et les régions dopées d'un second type sont connectées de manière continue et intégrale ; dans lequel le premier plan est une section longitudinale du modulateur à base de silicium, et le premier plan correspondant aux lignes d'intersection présentées comme les lignes rectangulaires en forme d'onde brisée et le premier plan correspondant aux lignes d'intersection présentées comme les lignes en forme de L brisée sont deux plans différents.

2. Modulateur à base de silicium selon la revendication 1, dans lequel la premier région de contact fortement dopée, la région dopée d'un premier type, la région dopée d'un second type et la seconde région de contact fortement dopée sont respectivement des régions p+, p, n et n+, ou respectivement des régions n+, n, p et p+.

3. Modulateur à base de silicium selon la revendication 1, dans lequel la pluralité de régions dopées d'un premier type en forme de bandes et la pluralité de régions dopées d'un second type en forme de bandes sont toutes parallèles à un plan de contact entre la première région de contact fortement dopée ou la seconde région de contact fortement dopée et la région de travail du bras de modulation.

4. Procédé de fabrication d'un modulateur à base de silicium selon les revendications 1-3, **caractérisé en ce que** le procédé comprend :
former un substrat dopé d'un premier type, et fabriquer un guide d'onde optique à partir du substrat dopé d'un premier type en utilisant un procédé de gravure ;
former des régions de contact sur les deux côtés du guide d'ondes optiques en utilisant le processus de gravure, puis injecter des ions d'un premier type ou des ions d'un second type avec une concentration déterminée dans les deux régions de contact respectivement en utilisant une méthode d'injection d'ions, pour former une première région de contact fortement dopée et une seconde région de contact fortement dopée ;
le procédé comprenant en outre :
établir un motif de la région dopée d'un second type sur un plan horizontal en utilisant le processus de gravure, puis injecter des ions d'un second type avec une concentration déterminée en utilisant la méthode d'injection d'ions, et former la région dopée d'un second type par recuit, pour obtenir la région de travail du bras de modulation ;
dans lequel une zone d'une région de contact formée entre une région dopée d'un premier type et la région dopée d'un second type dans la région de travail du bras de modulation est plus grande qu'une zone d'une plus petite région de contact entre la région dopée d'un premier type et la région dopée d'un second type ;
dans lequel la détermination d'un motif de la région dopée d'un second type sur un plan horizontal en utilisant le processus de gravure, puis l'injection d'ions d'un second type avec une concentration déterminée en utilisant la méthode d'injection d'ions, et la formation de la région dopée d'un second type par recuit, pour obtenir la région de travail du bras de modulation comprend :
établir le motif de la région dopée d'un second type sur un plan horizontal en utilisant le processus de gravure ;
injecter verticalement et longitudinalement les ions d'un second type dans une région de motif correspondant à la région dopée d'un second type, et retirer un matériau photosensible de la région dopée d'un premier type ;
injecter les ions d'un second type dans le guide d'ondes optiques une ou plusieurs fois dans une zone angulaire déterminée ; et
recuire et activer les ions d'un second type injectés pour former la région dopée d'un second type avec la concentration d'ions déterminée, pour obtenir la région de travail du bras de modulation.

5. Procédé selon la revendication 4, dans lequel le motif est une pluralité de bandes espacées les unes des autres ;
dans lequel la zone angulaire déterminée est : un angle de 15 à 75 degrés par rapport à une direction verticale, et parallèlement à une ligne de connexion horizontale entre la première région de contact fortement dopée et la seconde région de contact fortement dopée.

6. Procédé selon la revendication 4, dans lequel le motif est une forme de matrice de points ;
dans lequel la zone angulaire déterminée est : un angle de 15 à 75 degrés par rapport à une direction verticale, et parallèlement à une ligne de connexion horizontale entre la première région de contact fortement dopée et la seconde région de contact fortement dopée.
